# EUROPEAN PATENT APPLICATION

(11) **EP 4 727 015 A1**
(43) Date of publication of application: **15.04.2026**
(21) Application number: 25207504.9
(22) Date of filing: 08.10.2025
(51) Int. Cl.: H03L 7/08, H03L 7/081

(54) **SYSTEMS AND METHODS FOR PROVIDING CLOCK SIGNALS**

(30) Priority: 11.10.2024 US 202418913225
(71) Applicant: Avago Technologies International Sales Pte. Limited, Singapore 768923 (SG)
(72) Inventor: Schell, Robert, Chatham, 07928 (US)
(74) Representative: Dilg, Haeusler, Schindelmann Patentanwaltsgesellschaft mbH

(57) **Abstract**

The present invention is directed to electrical circuits. According to a specific embodiment, the present invention provides a device that includes a clock generator configured to generate a first clock signal and a second clock signal, with the second clock signal locked to the first clock signal. The device further includes an input path configured to carry an input signal, an injection circuit configured to provide the second clock signal into the input path during calibration, and a plurality of delay elements configured to generate a plurality of delayed signals using the first clock signal. There are other embodiments as well.

## Description

### FIELD OF INVENTION

The present invention is directed to electrical circuits.

### BACKGROUND OF THE INVENTION

With the increasing demand for high-speed data processing and transmission in modern communication systems, there is a need for innovative circuit architectures capable of handling high aggregate data rates. High-performance applications, such as those found in cloud computing and chip-to-chip interfaces, often require data rates exceeding 100 Gb/s per channel. Achieving these high data rates poses challenges for traditional circuit designs, which are often limited by factors such as clock frequency, timing precision, and signal integrity.

To address these limitations, techniques have been developed to enhance the performance of high-speed circuits. One approach is time-interleaving, which involves the use of multiple circuits operating in parallel at reduced data rates to achieve the desired throughput. This method enables the system to distribute the processing load across multiple channels, allowing each circuit to operate at a lower frequency while contributing to the overall data rate. As a result, time-interleaving offers a viable solution for improving data rate capabilities while mitigating issues associated with high-frequency operation, such as increased power consumption and timing errors.

Providing clock signals is an important aspect of communication systems. Unfortunately, existing systems and methods are inadequate, and improved systems and methods are desired.

### BRIEF DESCRIPTION OF THE DRAWINGS

Figure 1 is a simplified diagram illustrating a device with clock calibration according to embodiments of the present invention.
Figure 2 is a simplified block diagram illustrating a device that implements clock calibration mechanism according to embodiments of the present invention.
Figure 3 illustrates injection circuits according to embodiments of the present invention.
Figure 4A is a simplified timing diagrams illustrating spacing for clock signals.
Figure 4B is a timing diagram illustrating the behavior of various signals in a high-speed receiver system during a calibration scenario where a clock spacing error is present.
Figure 5A is a timing diagram illustrating the effects of a non-ideal duty cycle of the injection signal V_IN according to embodiments of the present invention.
Figure 5B is a timing diagram illustrating the resulting behavior of sub-rate sampling clocks after the calibration according to embodiments of the present invention.

### DETAILED DESCRIPTION OF THE INVENTION

The present invention is directed to electrical circuits. According to a specific embodiment, the present invention provides a device that includes a clock generator configured to generate a first clock signal and a second clock signal, with the second clock signal locked to the first clock signal. The device further includes an input path configured to carry an input signal, an injection circuit configured to provide the second clock signal into the input path during calibration, and a plurality of delay elements configured to generate a plurality of delayed signals using the first clock signal. There are other embodiments as well.

As mentioned above, time-interleaving is a useful technique. In time-interleaved systems, several sub-rate circuits are used to sample incoming data at different times, thus achieving higher effective data rates. For example, if a set of N=4 sampling circuits is used, each circuit operates at 1/Nth of the total data rate. This approach requires precise clock signals with accurate timing references to ensure that each sampling circuit captures data at the correct instant. However, achieving such precision is challenging, as timing errors at the sampling instants can lead to significant data integrity issues.

A problem in existing approaches arises due to clock skew and mismatched arrival times of the clock signals at the sampling circuits. While it is possible to generate equally spaced clock signals at the source using a clock generator, maintaining this timing accuracy at the sampling destination becomes difficult. Analog mismatches in the signal paths can cause timing differences, leading to unequal arrival times of clock edges at the sampling circuits. These timing mismatches can result in data errors or inefficient data recovery, particularly in high-speed communication systems where precise clock alignment is crucial.

It is to be appreciated that the present invention, in various embodiments, provides systems and methods for accurate calibration of clock signals at the sampling destination.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the present invention is not intended to be limited to the embodiments presented, but is to be accorded the widest scope consistent with the principles and novel features disclosed herein.

In the following detailed description, numerous specific details are set forth in order to provide a more thorough understanding of the present invention. However, it will be apparent to one skilled in the art that the present invention may be practiced without necessarily being limited to these specific details. In other instances, well-known structures and devices are shown in block diagram form, rather than in detail, in order to avoid obscuring the present invention.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes a device comprising: a clock generator configured to generate a first clock signal and a second clock signal, the second clock signal being locked to the first clock signal, the clock generator comprising a programmable delay and a voltage-controlled oscillator; an input path configured to carry an input signal; a switch configured to disconnect the input signal from the input path during calibration; an injection circuit coupled to the clock generator and the input path, the injection circuit being configured to provide the injection clock signal to the input path during calibration; a plurality of delay elements configured to provide delays to the first clock signal to generate a plurality of delayed signals; and a sampling circuit coupled to the input path and the plurality of delay elements, the sampling circuit being configured to sample a voltage signal on the input path using at least the plurality of delayed signals.

Implementations may include one or more of the following features. The second clock is phase-locked and/or frequency-locked to the first clock signal. The voltage-controlled oscillator is configured to generate a predetermined sequence during the calibration. The device further comprises a controller configured to generate control signals to adjust the variable delay elements based on a comparison of the phases of the output signals. The device further comprises a controller configured to adjust an equalizer configured on the input path. The input path comprises an equalizer. The device further comprises a first divider configured to generate a plurality of clock signals characterized by different phases using at least the first clock signal. The device further comprises clock and data recovery logic (CDR) coupled to the sampling circuit and the clock generator. The voltage-controlled oscillator operates at a predetermined frequency during the calibration. The injection circuit comprises a common-mode configuration. The input path comprises a variable gain amplifier. The injection circuit is configured to provide a first signal in a first polarity and a second signal in a second polarity, the first polarity and the second polarity being opposite.

Another general aspect includes a device comprising: a clock generator configured to generate a first clock signal and a second clock signal, the second clock signal being phase-locked and frequency-locked to the first clock signal, the clock generator comprising a programmable delay and a voltage-controlled oscillator; an input path configured to carry an input signal, the input path comprising an equalizer; a switch coupled to the input path, the switch being configured to disconnect the input signal from the input path during calibration; an injection circuit coupled to the clock generator and the input path, the injection circuit being configured to provide the second clock signal into the input path during calibration; a first clock divider configured to divide the first clock signal and generate a plurality of clock signals having different phases; a plurality of delay elements configured to provide delays to the plurality of clock signals to generate delayed clock signals; and a sampling circuit coupled to the input path and the plurality of delay elements, the sampling circuit being configured to sample a voltage signal on the input path using the delayed clock signals.

Implementations may include one or more of the following features. The device further comprises a variable gain amplifier configured on the input path. The device further comprises a controller configured to generate the control signal for the variable gain amplifier based on an amplitude of the input signal during calibration. The programmable delay in the clock generator is configured to provide phases of the second clock signal during calibration.

Yet another general aspect includes a device comprising: a clock generator configured to generate a first clock signal and a second clock signal, the second clock signal being locked to the first clock signal, the clock generator comprising a programmable delay and a voltage-controlled oscillator; an input path configured to carry an input signal, the input path comprises an equalizer; a switch configured to disconnect the input signal from the input path during calibration; an injection circuit coupled to the clock generator and the input path, the injection circuit being configured to provide the second clock signal as an injection clock signal to the input path during the calibration; a plurality of delay elements configured to provide delays to the first clock signal to generate a plurality of delayed signals; a sampling circuit coupled to the input path and the plurality of delay elements, the sampling circuit being configured to sample a voltage signal on the input path using at least the plurality of delayed signals; and a controller configured to adjust the equalizer based on detected signal characteristics during the calibration. In one or more implementations, the controller is configured to generate control signals to adjust the plurality of delay elements. The injection circuit is configured to provide the second clock signal as a differential signal into the input path. A known sequence is provided during the calibration.

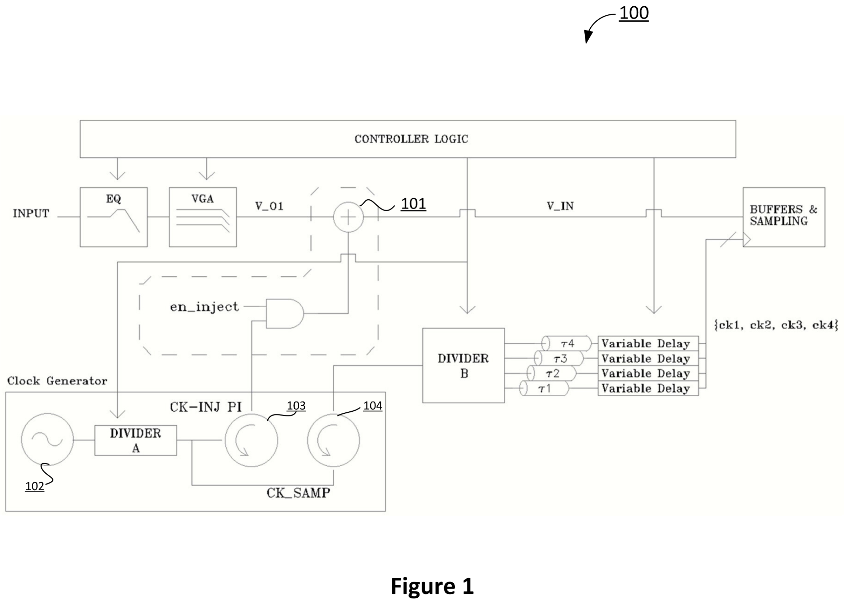

Figure 1 is a simplified diagram illustrating a device with clock calibration according to embodiments of the present invention. This diagram is merely an example, which should not unduly limit the scope of the claims. One of ordinary skill in the art would recognize many variations, alternatives, and modifications. As an example, device 100 may be configured for use in high-speed serializer/deserializer (SERDES) receiver systems. In such systems, maintaining precise clock alignment is critical, especially when the received signal exhibits a "closed eye" pattern (e.g., eye diagram indicating significant signal degradation) due to signal degradation. In various implementations, device 100 comprises components of the SERDES receiver (RX) systems, along with an injection circuit, to perform foreground calibration of clock spacing errors, ensuring that the errors are minimized before other analog and background digital control loops are activated.

The clock generator in the system includes a voltage-controlled oscillator (VCO) 102, which may operate under the control of clock and data recovery (CDR) logic to lock onto the incoming data signal. As an example, the term "clock generator" may refer to a circuit or system that produces one or more clock signals with a specific frequency, phase, and timing characteristics used to coordinate the timing of operations in digital and analog circuits. Examples of clock generators may include, without limitation, phase-locked loop (PLL)-based clock generators, delay-locked loop (DLL)-based clock generators, digitally controlled oscillators (DCOs), and/or the like. In some examples, a VCO may include an oscillator circuit whose output frequency can be adjusted over a range based on a control voltage input, making it suitable for generating clock signals with tunable frequencies in high-speed communication systems. During calibration, the VCO may output a predetermined fixed frequency or lock to a reference clock rather than the input data. The clock generator also comprises a Divider A that provides a sampling clock signal CK_SAMP. As shown, the signal from Divider A is provided to a CK-INJ phase interpolator (PI) 103, which generates an injection clock signal CK-INJ that may be phase and/or frequency-locked to CK_SAMP. As an example, a phase interpolator broadly refers to a circuit or device that generates an output signal, which may provide a delay or an adjustable phase based on two or more input signals with known phases. For example, CK-SAMP PI 104 may be configured to adjust the phase of the sampling clock to ensure proper alignment. For example, a phase interpolator may comprise a digitally controlled delay element.

For example, the term "phase locked" refers to a condition in which the phase of one signal is aligned or synchronized with the phase of another reference signal. When two signals are phase locked, the difference between their phases remains constant over time, ensuring that their rising and falling edges occur at predictable intervals relative to each other. As an example, the term "frequency locked" refers to a condition in which the frequency of one signal is matched or synchronized to the frequency of another reference signal. When two signals are frequency locked, they have the same number of cycles over a given period, but their phases may not necessarily be aligned.

The input path includes an equalizer (EQ) and a variable gain amplifier (VGA), which pre-condition the input signal. During calibration, the switch disconnects the input signal from the downstream path, and the injection circuit injects the CK-INJ clock signal into the input path. In various implementations, the injection circuit may be configured with one or more switches configured to disconnect the input signal from the input path to the sampling circuit. For example, "switch" in this context is broadly defined, and it broadly refers to a mechanism for disconnecting the input signal from the input pass, and it may be implemented by, as an example, powering down stages to provide isolation. Depending on the implementations, the injection circuit can be separate, where the input signal is removed from the input path. For example, an injection circuit may be a circuit or device designed to introduce a known signal, such as a clock, test, or calibration signal, into a specific node on a signal path or system. This process isolates the input signal, allowing the injected clock signal to reach the summation node 101, from which it is sent through the downstream circuitry for calibration purposes. For example, the circuit is quiet during calibration and introduces minimal loading to avoid degrading the signal path. For example, an input path refers to a sequence of interconnected components, circuits, or transmission lines through which an incoming signal travels from its source to various processing or measurement stages within a system. For example, an input path can include elements such as amplifiers, filters, equalizers, buffers, and switches,

The controller logic monitors signals and adjusts various parameters, such as the equalizer and delay elements, based on detected signal characteristics. The controller logic ensures that once the foreground calibration is complete, the injection circuit and any related components power down completely to prevent leakage or interference in the normal data path. For example, the term "control logic" or "controller" refers to digital or analog circuits, algorithms, or systems configured to manage and coordinate the operation of various components within a device or system based on specific rules, conditions, or inputs.

In various implementations, signals τ1, τ2, τ3, and τ4 denote the delay times of the sub-rate clock. The delayed time is provided to a set of variable delay elements that provide adjustments to the timing of the clock signals before they are sent to the Buffers & Sampling block. For example, the resulting sub-rate clock phases (ck1, ck2, ck3, ck4) may be used for sampling and processing data at various phases, ensuring accurate timing and reduced clock spacing errors. For example, delay elements are circuit components or devices used to introduce a controlled time delay to an input signal, thereby adjusting the timing of the signal's transitions at its output. Delay elements can vary the timing of digital or analog signals to achieve precise synchronization, phase alignment, or timing compensation within a system.

During the calibration, the injection clock CK-INJ is provided as a known signal into the input path to generate a clock-like pattern, allowing the system to evaluate the sampling instants and adjust the delay elements accordingly. For example, device 100 compares the outputs from the sampling circuits to determine when transitions between 1s and 0s occur, providing information about clock spacing errors. For example, a sampling circuit may be an electronic circuit designed to capture and measure the value of an input signal at specific time intervals, known as sampling instants.

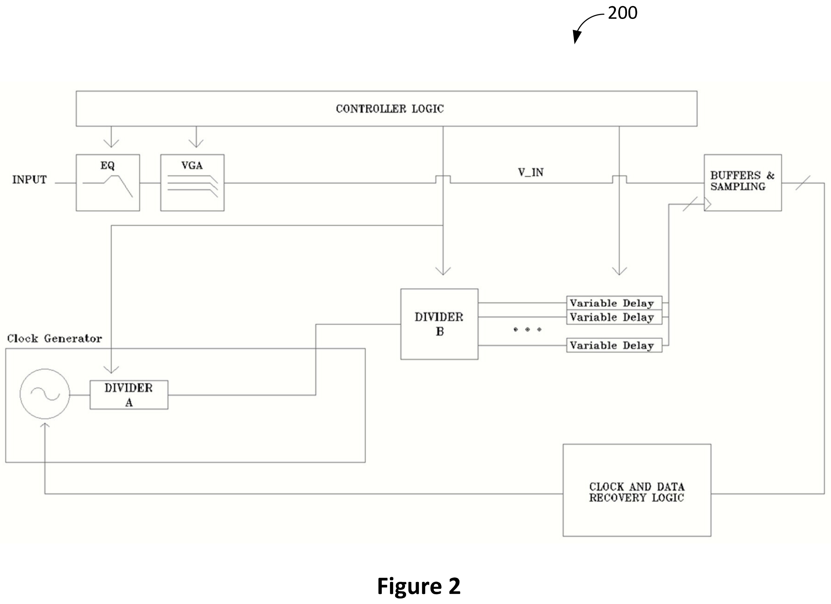

Figure 2 is a simplified block diagram illustrating a device that implements clock calibration mechanism according to embodiments of the present invention. This diagram is merely an example, which should not unduly limit the scope of the claims. One of ordinary skill in the art would recognize many variations, alternatives, and modifications. As an example, device 200 may be a SerDes receiving device that uses clock calibration mechanisms according to a specific embodiment of the present invention.

As an example, the clock generator in Figure 2 generates clock signals for sampling the incoming. The clock generator comprises a Divider A circuit, which divides the frequency of an input clock signal.

The input path includes an equalizer (EQ) block, which may condition the incoming input signal by compensating for frequency-dependent losses and correcting distortions caused by signal transmission over a communication channel. The equalized signal is then passed to a Variable Gain Amplifier (VGA), which adjusts the amplitude of the signal based on a control signal from the controller logic. This adjusted signal, labeled as V_IN, is provided to downstream circuits for further processing and analysis.

The controller logic, shown at the top of Figure 2, is for monitoring and controlling various components in the device, including the EQ, VGA, and delay elements. During calibration, the controller logic causes the input path to disconnect from downstream circuits, enabling the isolation of the input signal and the injection of a known calibration signal for clock alignment purposes. For example, the controller logic may generate control signals to adjust the settings of the EQ, VGA, and delay elements based on detected signal characteristics, ensuring optimal signal integrity and timing during both calibration and normal operation.

The clock signal, as provided by the clock generator, is provided to a Divider B circuit, which divides the sampling clock into multiple sub-rate clock signals. These sub-rate clock signals are routed to a set of variable delay elements. For example, each variable delay element applies a predetermined timing and/or phase delay to its corresponding sub-rate clock signal, thereby generating timed clock signals that allow for interleaving. The delayed clock signals are then provided to the buffers & sampling module for processing.

As an example, the buffers & sampling module receives the delayed sub-rate clock signals from the variable delay elements and utilizes these signals to sample the input signal V_IN. By sampling the input signal at precise time intervals corresponding to the delayed clock signals, this module ensures that timing errors are minimized, and the incoming data is accurately acquired and processed.

The clock and data recovery logic block, shown at the bottom right of Figure 2, is coupled to the buffers & sampling module and the clock generator. For example, the CDR block may be configured for aligning the recovered clock signal with the incoming data stream during normal operation. In various embodiments, the CDR block ensures that the timing and phase of the recovered clock signals are properly synchronized with the input data, allowing for reliable data recovery even under varying signal conditions.

During normal operation, the input signal is processed through the EQ and VGA before being sent to the sampling circuits. The clock generator produces sampling clocks that are divided and delayed to achieve accurate timing alignment. In the calibration, the controller logic caused the input signal to be disconnected from the downstream sampling circuits and allow a known clock signal, which is phase-locked and/or frequency-locked to the clock generator's sampling clock, to be injected into the input path. For example, the injected signal is used to determine timing errors between different clock phases and sub-rate signals. The outputs from the sampling circuits may be used to detect timing mismatches and adjust the delay elements based on these measurements, ensuring that clock spacing errors are minimized.

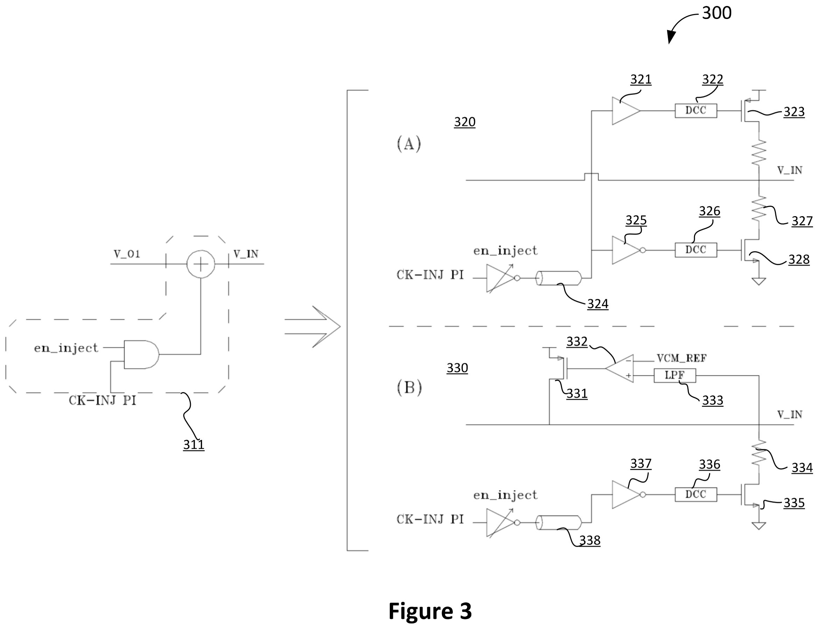

Figure 3 illustrates injection circuits according to embodiments of the present invention. This diagram is merely an example, which should not unduly limit the scope of the claims. One of ordinary skill in the art would recognize many variations, alternatives, and modifications.

As an example, an injection circuit is for introducing a known calibration signal into the signal path (e.g., input signal path in Figures 1 and 2) without disrupting the normal operation of the receiver or affecting the common-mode voltage of the input signal. The injection circuit is configured to ensure that clock alignment and signal integrity can be maintained during the foreground calibration phase.

The left side of Figure 3 shows a simplified version of the injection circuit, where the input signal V_01 is combined with the injected clock signal at a summation node, resulting in an output signal V_IN. The injection circuit is enabled by an enable signal en_inject. When the enable signal is high, the CK-INJ PI 311 injects a clock signal into the input path. The programmable delay provides a known, phase- and/or frequency-locked clock signal to ensure that the injected signal is aligned with the internal clock reference of the receiver. The programmable delay, which may include digitally controlled delay lines, phase interpolators, or variable delay elements, provides flexibility in adjusting the timing of the clock signal.

The right side of Figure 3 illustrates two different implementations for the injection circuit: Option (A) and Option (B). Option (A) 320 shows a complementary signal injection configuration. In this configuration, the injected signal is created differentially, which means that both positive and negative phases of the clock signal are used to pull the input signal V_IN up and down. This differential injection maintains the common-mode voltage of V_IN at a constant level, preventing the DC bias of the signal from being altered. The circuit includes a pair of duty cycle correction (DCC) circuits 322 and 326 that are coupled to the differential signal injectors 323, 327 to ensure a 50% duty cycle for the injected clock signal. The injection is controlled by an enable signal 324 from the CK-INJ PI. When enabled, the clock signal is injected into the path, and the differential nature of the circuit ensures that the common-mode voltage remains unchanged even as the signal is pulled above and below the static level.

Option (B) 330 shows a configuration using a common-mode control loop. Instead of using complementary differential signals, this configuration uses a single-ended signal injector 335. For example, circuit 330 includes a p-type metal-oxide-semiconductor (pMOS) transistor 331 that pulls the signal up and an n-type metal-oxide-semiconductor (nMOS) transistor 335 that pulls the signal down, ensuring that the signal reaches the desired voltage levels. Resistor 334 may be used to stabilize the voltage at the V_IN node by limiting the current flowing through the pMOS transistor 331. In various implementations, the common-mode voltage is monitored and maintained using a separate low-frequency path that includes a voltage comparator 332, a lowpass filter (LPF) 333, and a reference common-mode voltage signal VCM_REF. This configuration allows the common-mode voltage of V_IN to be kept constant without the need for additional components to touch the signal directly, reducing the circuit's complexity and load. For example, in option (B) 330, the common-mode control loop minimizes the impact of the injected clock signal on the input path. The configuration is useful when the system already has an existing common-mode control loop, such as one integrated into a preceding stage like a VGA. It is to be appreciated that in various implementations, the injection circuit does not add significant overhead or complexity, as the pMOS transistor 331 may be built into the VGA stage.

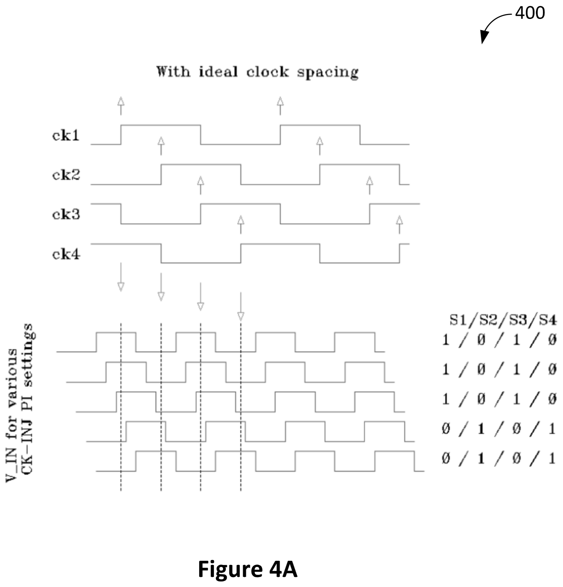

Figure 4A is a simplified timing diagram illustrating spacing for clock signals. At the top of Figure 4A, four sampling clock signals are shown, labeled as ck1, ck2, ck3, and ck4. Each rising edge of these clock signals represents a sampling instant, which is indicated by upward arrows. In this example, the four sampling clocks are used for an N = 4 sub-rate sampling system, meaning that each sampling clock captures a portion of the input signal at different time intervals. The ideal spacing between the rising edges of ck1 through ck4 ensures uniform and precise sampling.

The lower part of Figure 4A illustrates multiple representations of the analog input voltage signal V_IN as it appears at the input of the sampling comparators. The signal V_IN is shown for various settings of the CK-INJ PI. As the settings of the CK-INJ PI are adjusted, the waveform of V_IN shifts horizontally relative to the sampling clock signals. This horizontal shift simulates the effect of delaying the injection clock signal in relation to the sampling clock signals. As shown, increasing the delay setting of CK-INJ PI causes V_IN to move progressively to the right in the figure.

When CK-INJ and CK_SAMP are frequency-locked, V_IN appears as a repetitive 1010 pattern. For the initial CK-INJ PI setting at the top, the clock signals ck1 through ck4 sample the V_IN waveform at specific points such that the comparators yield outputs corresponding to a "1 0 1 0" pattern. This output pattern is static and will not change unless the relative timing of the sampling clocks or the input signal is altered. As the CK-INJ PI setting is adjusted and the V_IN waveform shifts further to the right, each sampling clock signal starts to capture a different part of the V_IN waveform. With a 50% duty cycle on the V_IN signal, as the delay of CK-INJ PI increases, the comparator outputs eventually transition to a different pattern, such as "0 1 0 1." This transition occurs when the sampling clocks sample the opposite phases of the V_IN waveform.

In Figure 4A, at one particular CK-INJ PI setting, all four comparator outputs switch simultaneously from "1 0 1 0" to "0 1 0 1," indicating that the sampling instants are aligned to within the time-step resolution of the CK-INJ PI. This alignment shows that the foreground calibration has been successfully achieved with ideal clock spacing, and the resulting alignment is sufficient to meet the calibration requirements. The output patterns of the comparators, labeled as S1/S2/S3/S4, correspond to the states of the four sampling comparators at each CK-INJ PI setting. For example, at the initial CK-INJ PI setting, the comparator outputs are "1 / 0 / 1 / 0." As the delay is increased, the outputs change as the sampling instants capture different parts of the V_IN waveform. As an example, the transition from "1 0 1 0" to "0 1 0 1" observed in Figure 4A serves as an indication that the calibration process has aligned the clock phases correctly. The change in the output patterns provides valuable information that can be used to determine if any clock spacing errors are present. If all four comparator outputs change simultaneously, it confirms that the clock phases are evenly spaced, meeting the required resolution for foreground calibration.

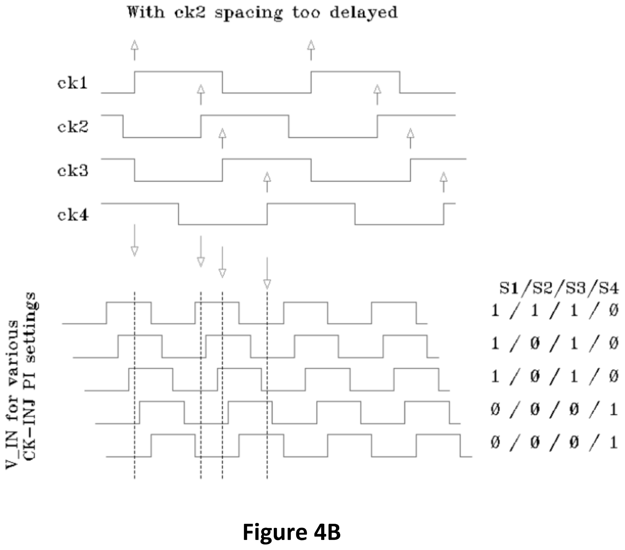

Figure 4B is a timing diagram illustrating the behavior of various signals in a high-speed receiver system during a calibration scenario where a clock spacing error is present. For example, one of the sub-rate clock signals, ck2, is delayed relative to the other clock signals, causing timing mismatches during sampling. At the top of Figure 4B, the sampling clock signals ck1, ck2, ck3, and ck4 are shown. These signals represent the timing of sampling instants in the receiver system. However, unlike in Figure 4A where clock signals were evenly spaced, ck2 in Figure 4B is shifted to the right, indicating that its rising edge is delayed compared to its ideal position. This delay means that the time interval between the rising edges of ck1 and ck2 is longer than the intervals between ck2 and ck3, ck3 and ck4, and ck4 and ck1. Such clock spacing errors can significantly affect the accuracy of data sampling and cause timing mismatches.

The lower part of Figure 4B shows the timing of the analog input voltage signal V_IN for various settings of the CK-INJ PI. As in Figure 4A, the V_IN waveform shifts to the right as the delay setting of the CK-INJ PI is increased. Each configuration of V_IN corresponds to a different CK-INJ PI setting, allowing the system to observe how the sampling clocks interact with the signal at different time instants. Because of the clock spacing error, the comparators associated with the sampling clocks ck1, ck2, ck3, and ck4 produce different output patterns at the same CK-INJ PI setting. This behavior is evident from the comparator outputs labeled as S1/S2/S3/S4 on the right side of the figure. Unlike in Figure 4A, where all comparator outputs transitioned simultaneously due to ideal clock spacing, the delayed ck2 signal in Figure 4B causes the comparator outputs to change at different times.

For example, at the initial CK-INJ PI setting, the comparator outputs are "1 / 1 / 1 / 0." As the CK-INJ PI setting changes, the comparator outputs sequentially transition through various states, such as "1 / 0 / 1 / 0," "1 / 0 / 1 / 0," "0 / 0 / 0 / 1," and "0 / 0 / 0 / 1." This progression of output patterns indicates that ck2 is not correctly aligned with the other clock signals, as the comparators corresponding to ck2 generate different outputs relative to the other comparators. The sequential changes in the comparator outputs, instead of a simultaneous change across all outputs as in Figure 4A, serve as an indicator of which clock signal is in error. In this case, the delayed ck2 signal causes the staggered transitions in the comparator outputs. By analyzing this progression, a state machine or controller (e.g., control logic in Figure 1) can determine which clock path is causing the error and adjust the corresponding variable delay element in front of the ck2 path to bring it back in line with the other clock signals.

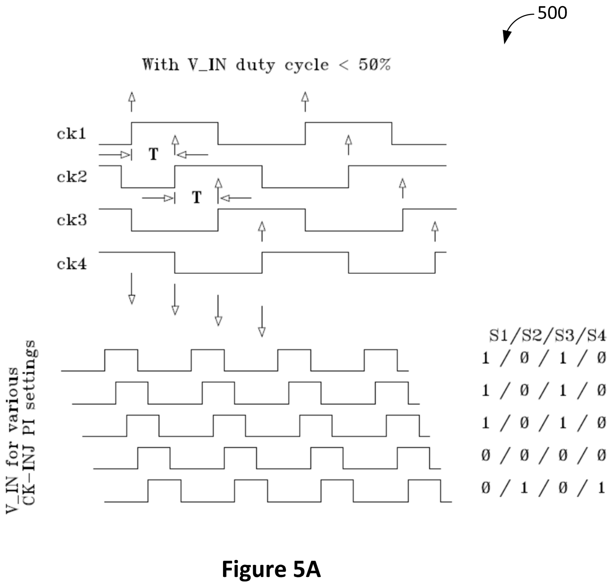

Figure 5A is a timing diagram illustrating the effects of a non-ideal duty cycle of the injection signal V_IN according to embodiments of the present invention. This diagram is merely an example, which should not unduly limit the scope of the claims. One of ordinary skill in the art would recognize many variations, alternatives, and modifications. For example, V_IN affects the timing alignment of sub-rate sampling clocks in a high-speed receiver system (e.g., device 100 in Figure 1 and device 200 in Figure 2). As shown, deviations in the duty cycle from the desired 50% can cause timing errors during the calibration process, ultimately leading to skewed clock spacing.

At the top of Figure 5A, four sampling clock signals, labeled ck1, ck2, ck3, and ck4, are shown with their respective rising edges indicated by upward arrows. Ideally, each clock signal should be spaced evenly by a time interval T, resulting in uniform sampling instants. In the figure, the time interval T between the rising edges of the clocks represents the desired clock spacing for accurate data sampling. However, the analog input signal V_IN in this example has a duty cycle of less than 50%. This non-ideal duty cycle is shown in the lower part of the figure, where V_IN is depicted for various settings of the CK-INJ Phase Interpolator (PI). As the delay setting of the CK-INJ PI is increased, V_IN shifts horizontally relative to the sampling clocks, allowing the system to evaluate different sampling points on the waveform.

Due to the imperfect duty cycle of V_IN, the transition from one comparator output pattern to another does not occur cleanly. For instance, when sweeping the CK-INJ PI settings, the system does not observe a smooth transition between a "1 0 1 0" pattern and a "0 1 0 1" pattern, as would be expected with an ideal 50% duty cycle. Instead, there is a region where all comparator outputs might be "0 0 0 0," indicating that the clocks are sampling during an extended low period of V_IN. If the duty cycle of V_IN were greater than 50%, this region would show as all comparators reading "1 1 1 1" instead. The output patterns of the comparators are represented by S1/S2/S3/S4 on the right side of the Figure 5A. At the initial CK-INJ PI setting, the comparator outputs are "1 / 0 / 1 / 0." As the delay setting is changed, the outputs transition through patterns such as "1 / 0 / 1 / 0," "0 / 0 / 0 / 0," and finally to "0 / 1 / 0 / 1." The presence of the "0 / 0 / 0 / 0" state indicates that the clocks are not sampling the signal as intended due to the V_IN duty cycle being less than 50%.

When the algorithm used for calibration encounters such a situation, it attempts to converge the clock timings to a state where a clean transition between "1 0 1 0" and "0 1 0 1" is observed. However, this convergence often results in the clock signals being skewed. After convergence, some clock spacings may be shorter than T, while others may be longer than T, which is the opposite of the desired equal spacing.

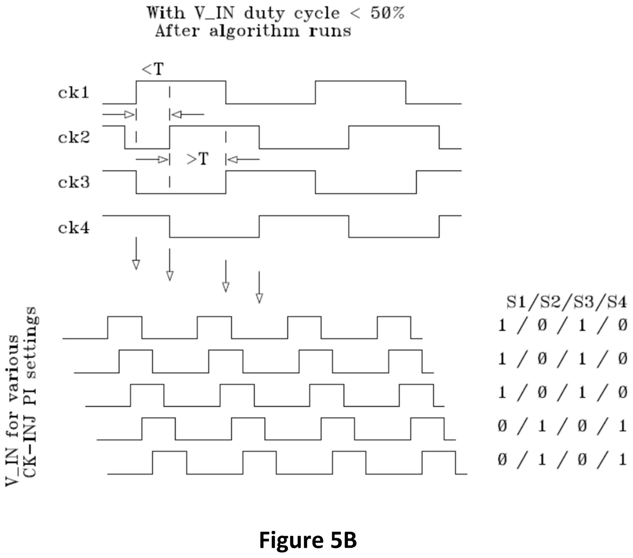

Figure 5B is a timing diagram illustrating the resulting behavior of sub-rate sampling clocks after the calibration according to embodiments of the present invention. This diagram is merely an example, which should not unduly limit the scope of the claims. One of ordinary skill in the art would recognize many variations, alternatives, and modifications. For example, the timing diagram is provided under the conditions where the injection signal V_IN has a duty cycle of less than 50%. Figure 5B shows how an imperfect duty cycle affects the alignment of the sampling clocks, even after the algorithm attempts to achieve equal spacing.

At the top of Figure 5B, four sampling clock signals are shown, labeled as ck1, ck2, ck3, and ck4. Each rising edge of these clocks, indicated by upward arrows, represents a sampling instant. Ideally, the sampling clocks should be uniformly spaced with equal intervals T between their rising edges. However, as shown in the figure, the spacing of the clocks is skewed due to the calibration misalignment. Specifically, the time interval between the rising edges of ck1 and ck2 is shorter than the desired interval T, indicated as "<T." Similarly, the interval between ck2 and ck3 is longer than the desired interval T, indicated as ">T." These unequal spacings arise because the calibration algorithm, when operating with a non-ideal duty cycle of V_IN, converges to a solution that minimizes clock spacing errors in a non-uniform manner. As a result, the spacing of some clock signals is compressed, while others are stretched.

The lower part of Figure 5B shows several representations of the analog input voltage signal V_IN for different settings of the CK-INJ PI, similar to the previous figures. As the delay setting of CK-INJ PI increases, V_IN shifts horizontally, allowing the sampling clocks to capture different points on the waveform. However, due to the non-ideal duty cycle of V_IN, the comparator outputs do not transition smoothly between patterns, causing the calibration algorithm to misalign the clocks. The output patterns of the sampling comparators, labeled as S1/S2/S3/S4, are shown on the right side of Figure 5B. These patterns indicate the states of the four comparators at each CK-INJ PI setting. Initially, the comparator outputs are "1 / 0 / 1 / 0," representing a correct sampling of the alternating pattern of V_IN. As the delay setting changes, the outputs transition through states such as "1 / 0 / 1 / 0," "0 / 1 / 0 / 1," and finally stabilize at "0 / 1 / 0 / 1."

The comparator output transitions demonstrate that, while the algorithm can still adjust the sampling clocks based on the detected signal, the non-ideal duty cycle of V_IN results in unequal clock spacing after convergence. For example, the transitions between "1 / 0 / 1 / 0" and "0 / 1 / 0 / 1" are not as clean and synchronized as they would be with a 50% duty cycle for V_IN. Instead, the presence of intermediate states such as "0 / 0 / 0 / 0" (as seen in Figure 5A) indicates that the algorithm is compensating for the duty cycle error by misaligning the clock phases.

As shown in Figure 5B, when the duty cycle of V_IN is not 50%, the calibration algorithm may converge to a non-ideal clock alignment, with some clock intervals being shorter and others being longer than the desired interval T. This misalignment can degrade the performance of the system by causing timing errors during sampling. To avoid this issue, duty cycle correction (DCC) circuits, as described in Figure 3, are used to ensure that V_IN has a precise 50% duty cycle before the calibration algorithm is executed.

As an example, foreground clock calibration may be used in high-speed receivers, such as SERDES systems, to ensure accurate timing alignment and minimal clock spacing errors. For example, in SERDES receiver systems, sub-rate sampling clocks are used to capture high-speed data at multiple sampling instants. Embodiments of the present invention can accommodate various configurations of clock dividers and sub-rate sampling clock arrangements. For example, in a system where the sampling clocks ck1, ck2, ck3, and ck4 have the same frequency as the main sampling clock CK_SAMP, the invention's injection method may be applied effectively.

It is understood that embodiments of the present invention are not limited to systems with N = 4 sub-rate sampling clocks, as described in some examples. For example, implementations of the present invention can also be adapted to systems with a greater number of sub-rate sampling clocks, such as N = 8 or other values. For example, a control logic may be modified to identify different alignment points, but the calibration method remains applicable.

Some implementations help eliminate the need for DCC circuits, as shown in Figure 3. In these implementations, an algorithm according to the present invention analyzes the rising edges of the sub-rate sampling clock (e.g., rather than analyzing both rising and falling edges), which would be feasible if the CK-INJ PI, or the delay control element for the injection signal V_IN, exhibits near perfect linearity and sufficient delay range. By focusing on the rising edges only, the calibration algorithm can avoid issues caused by non-ideal duty cycles and reduce the complexity of the circuitry.

As data rates continue to increase in future generations of systems (e.g., SERDES receivers), it is expected that the bit time of transmitted data will decrease, leading to more stringent requirements for clock spacing accuracy. In such scenarios, the foreground clock calibration techniques herein will become increasingly important for reliable high-speed data transmission.

While the above is a full description of the specific embodiments, various modifications, alternative constructions and equivalents may be used. Therefore, the above description and illustrations should not be taken as limiting the scope of the present invention which is defined by the appended claims.

## Claims

1. A device comprising:
a clock generator configured to generate a first clock signal and a second clock signal, the second clock signal being locked to the first clock signal, the clock generator comprising a programmable delay and a voltage-controlled oscillator;
an input path configured to carry an input signal;
a switch configured to disconnect the input signal from the input path during calibration;
an injection circuit coupled to the clock generator and the input path, the injection circuit being configured to provide the injection clock signal to the input path during calibration;
a plurality of delay elements configured to provide delays to the first clock signal to generate a plurality of delayed signals; and
a sampling circuit coupled to the input path and the plurality of delay elements, the sampling circuit being configured to sample a voltage signal on the input path using at least the plurality of delayed signals.

2. The device of claim 1, wherein
the second clock is phase-locked and/or frequency-locked to the first clock signal.

3. The device of claim 1 or 2, wherein
the voltage-controlled oscillator is configured to generate a predetermined sequence during the calibration.

4. The device of any one of the preceding claims, further comprising
a controller configured to generate control signals to adjust the variable delay elements based on a comparison of the phases of the output signals.

5. The device of any one of the preceding claims, further comprising
a controller configured to adjust an equalizer configured on the input path.

6. The device of any one of the preceding claims, wherein
the input path comprises an equalizer.

7. The device of any one of the preceding claims, further comprising
a first divider configured to generate a plurality of clock signals **characterized by** different phases using at least the first clock signal.

8. The device of any one of the preceding claims, further comprising
clock and data recovery logic (CDR) coupled to the sampling circuit and the clock generator.

9. The device of any one of the preceding claims, wherein
the voltage-controlled oscillator operates at a predetermined frequency during the calibration.

10. The device of claim 1, wherein the device comprises at least one of the following features:
the injection circuit comprises a common-mode configuration;
the input path comprises a variable gain amplifier; and
the injection circuit is configured to provide a first signal in a first polarity and a second signal in a second polarity, the first polarity and the second polarity being opposite.

11. A device comprising:
a clock generator configured to generate a first clock signal and a second clock signal, the second clock signal being phase-locked and frequency-locked to the first clock signal, the clock generator comprising a programmable delay and a voltage-controlled oscillator;
an input path configured to carry an input signal, the input path comprising an equalizer;
a switch coupled to the input path, the switch being configured to disconnect the input signal from the input path during calibration;
an injection circuit coupled to the clock generator and the input path, the injection circuit being configured to provide the second clock signal into the input path during calibration;
a first clock divider configured to divide the first clock signal and generate a plurality of clock signals having different phases;
a plurality of delay elements configured to provide delays to the plurality of clock signals to generate delayed clock signals; and
a sampling circuit coupled to the input path and the plurality of delay elements, the sampling circuit being configured to sample a voltage signal on the input path using the delayed clock signals.

12. The device of claim 11, further comprising
a variable gain amplifier configured on the input path; and/or
a controller configured to generate the control signal for the variable gain amplifier based on an amplitude of the input signal during calibration.

13. The device of claim 11 or 12, wherein
the programmable delay in the clock generator is configured to provide phases of the second clock signal during calibration.

14. A device comprising:
a clock generator configured to generate a first clock signal and a second clock signal, the second clock signal being locked to the first clock signal, the clock generator comprising a programmable delay and a voltage-controlled oscillator;
an input path configured to carry an input signal, the input path comprises an equalizer;
a switch configured to disconnect the input signal from the input path during calibration;
an injection circuit coupled to the clock generator and the input path, the injection circuit being configured to provide the second clock signal as an injection clock signal to the input path during the calibration;
a plurality of delay elements configured to provide delays to the first clock signal to generate a plurality of delayed signals;
a sampling circuit coupled to the input path and the plurality of delay elements, the sampling circuit being configured to sample a voltage signal on the input path using at least the plurality of delayed signals; and
a controller configured to adjust the equalizer based on detected signal characteristics during the calibration.

15. The device of claim 14, wherein the device comprises at least one of the following features the controller is configured to generate control signals to adjust the plurality of delay elements; the injection circuit is configured to provide the second clock signal as a differential signal into the input path; and
a known sequence is provided during the calibration.
